Europäisches Patentamt

European Patent Office

Office européen des brevets

(19)

(11) Numéro de publication : **0 182 430**
**B1**

(12) **FASCICULE DE BREVET EUROPÉEN**

(45) Date de publication du fascicule du brevet :
01.02.89

(51) Int. Cl.⁴ : **H 01 L 27/15, H 01 L 25/04**

(21) Numéro de dépôt : **85201836.5**

(22) Date de dépôt : **11.11.85**

(54) Matrice de diodes electroluminescentes et son procédé de fabrication.

(30) Priorité : **23.11.84 FR 8417894**

(43) Date de publication de la demande :
**28.05.86 Bulletin 86/22**

(45) Mention de la délivrance du brevet :
**01.02.89 Bulletin 89/05**

(84) Etats contractants désignés :
**DE FR GB NL**

(56) Documents cités :
**DE–A– 2 235 865**
**FR–A– 2 080 849**
**FR–A– 2 413 792**
**GB–A– 1 532 286**
**GB–A– 2 035 689**
**GB–A– 2 085 227**

(73) Titulaire : **RTC-COMPELEC**
**130, Avenue Ledru-Rollin**
**F-75011 Paris (FR)**
**FR**
**N.V. Philips' Gloeilampenfabrieken**
**Groenewoudseweg 1**
**NL-5621 BA Eindhoven (NL)**
**DE GB NL**

(72) Inventeur : **Varon, Jacques**
**Societe Civile S.P.I.D. 209, rue de l'Université**
**F-75007 Paris (FR)**
Inventeur : **Mahieu, Marc**
**Societe Civile S.P.I.D. 209, rue de l'Université**
**F-75007 Paris (FR)**

(74) Mandataire : **Jacquard, Philippe et al**
**SOCIETE CIVILE S.P.I.D. 209, rue de l'Université**
**F-75007 Paris (FR)**

Jouve, 18, rue St-Denis, 75001 Paris, France

## Description

La présente invention a pour objet une matrice de diodes électroluminescentes comportant au moins une couche active en matériau III-V d'un premier type de conductivité et une couche superficielle d'injection en matériau III-V du second type de conductivité opposé et des zones semi-isolantes disposées au moins suivant des colonnes et s'étendant sur l'épaisseur de la couche d'injection et de la couche active de manière à séparer au moins partiellement dans lesdites couches les diodes individuelles et à recevoir au moins une partie des contacts conducteurs.

Une telle matrice est connue de la demande de brevet français FR-A-2491714 au nom de la Demanderesse, déposée le 6 octobre 1980 et intitulée « DISPOSITIF SEMICONDUCTEUR A DIODES ELECTROLUMINESCENTES LOCALISEES ET SON PROCEDE DE FABRICATION ».

Cette demande décrit une matrice de diodes pour laquelle les contacts reliant ligne par ligne une électrode des diodes et l'autre électrode colonne par colonne sont disposés sur une face et présentent des languettes de contact situées au-dessus des régions actives d'émission. Cette disposition ne convient que pour des diodes intrinsèquement de grandes dimensions pour lesquelles la perte de lumière due aux languettes de contact n'est pas trop importante.

Selon l'invention, les contacts sont disposés sur deux races opposées de la matrice et celle-ci présente une couche de localisation enterrée qui permet de limiter la zone d'émission de chaque diode. Les contacts peuvent alors être disposés en dehors de la zone d'émission, donc sans perte de rendement, et sur une partie substantielle, et ou le cas échéant, sur tout le pourtour de chaque diode. La matrice selon l'invention est dans ce but caractérisée en ce que chaque zone semi-isolante s'étend depuis la surface de la couche d'injection jusqu'à une zone de localisation en matériau III-V de composition binaire et du second type de conductivité, les zones de localisation présentant en section transversale chacune une partie supérieure et une partie inférieure, les parties supérieures délimitant un réseau à deux dimensions d'alvéoles remplies par des prolongements de la couche active, et les parties inférieures étant espacées par régions semi-conductrices de contact électrique à niveau de dopage élevé du premier type de conductivité, disposées parallèlement aux lignes de manière à interconnecter les diodes ligne par ligne au niveau desdits prolongements et en ce qu'elle comporte, sur la couche d'injection, des métallisations de contact électrique comprenant, pour chaque diode, des régions de contact délimitées intérieurement sensiblement jusqu'à l'aplomb des parties supérieures des zones de localisation et interconnectées colonne par colonne, les colonnes d'interconnexion ainsi constituées étant isolées électriquement les unes par rapport aux autres par les zones semi-isolantes disposées selon les colonnes.

Les couches actives et d'injection peuvent être de composition binaire ou ternaire.

L'invention s'applique tout particulièrement au cas où la composition binaire est le GaAs et la composition ternaire le GaAlAs.

Selon un mode préféré, les zones semi-isolantes s'étendent également selon les lignes de manière à produire une isolation électrique optimale entre les diodes adjacentes.

L'invention concerne également un procédé de fabrication de la matrice précitée.

Dans ce procédé, conformément à l'art antérieur précité, une couche d'injection et une couche active du type III-V sont réalisées par hétéroépitaxie sur un substrat, et les diodes individuelles sont séparées au moins partiellement en bombardant des régions délimitées pour former au moins des colonnes de zones semi-isolantes sur l'épaisseur de la couche d'injection et de la couche active.

Le procédé de l'art antérieur conduit à une structure dont les inconvénients ont été mentionnés plus haut. Le procédé selon l'invention met en oeuvre des opérations de décapage de certaines couches épitaxiées permettant d'enterrer des lignes de contact et des zones de localisation, ces dernières limitant l'émission lumineuse à des régions pour lesquelles la lumière émise n'est pas absorbée par des contacts électriques déposés, d'où un rendement optimal.

Dans ce but, le procédé comporte les étapes suivantes :

-dépôt épitaxique sur le substrat d'une première couche III-V de composition binaire fortement dopée d'un premier type de conductivité.

-décapage dans ladite première couche d'un premier groupe d'ouvertures disposées parallèlement aux lignes selon un pas donné, les parties subsistantes de la première couche formant des régions semi-conductrices de contact électrique interconnectant les diodes ligne par ligne.

-dépôt épitaxique d'une deuxième couche III-V de composition binaire du second type de conductivité.

-dans le but de former une couche de localisation, décapage dans ladite deuxième couche III-V d'un second groupe d'ouvertures formant un réseau à deux dimensions décalé selon les lignes d'un demi-pas par rapport à celles du premier groupe, lesdites ouvertures de la deuxième couche étant ménagées à une partie supérieure de la couche de localisation qui recouvre en partie lesdites régions semi-conductrices de contact électrique.

-dépôt épitaxique successivement de la couche active du premier type de conductivité et de la couche d'injection du second type de conductivité.

-réalisation dudit bombardement,

-réalisation de métallisations de contact électrique sur la couche d'injection lesquelles comportent pour chaque diode d'une part des régions de contact s'étendant intérieurement parallèlement aux lignes sensiblement jusqu'à l'aplomb des parties supérieures de la couche de localisation et interconnectées colonne par colonne, les colonnes d'interconnexion ainsi constituées étant isolées électriquement les unes par rapport aux autres par les zones semi-isolantes disposées selon les colonnes

L'étape de bombardement peut être telle qu'elle forme également des lignes de régions semi-isolantes de manière à produire une isolation électrique optimale entre les diodes adjacentes.

La couche de composition binaire est avantageusement en As-Ga. Les couches actives et d'injection peuvent être de composition binaire, par exemple As-Ga, ou ternaire, par exemple GaAlAs.

L'invention sera mieux comprise à la lecture de la description qui va suivre donnée à titre d'exemple non limitatif, en liaison avec les figures qui représentent :

Les figures 1a à 1e, en coupe verticale, et pour les figures 1a et 1c en perspective, les différentes étapes du procédé de fabrication ;

la figure 2, une vue de dessus de la figure 1e ; et la figure 3, une variante de la figure 2.

Selon la figure 1a, un substrat 1 en GaAs semi-isolant ou bien de type n est revêtu par épitaxie liquide d'une couche 2 de GaAs de type p+ (dopée de l'ordre de $10^{19}$ cm$^{-3}$) et d'une épaisseur $e_0$ de l'ordre de 4 à 6 microns. On dépose sur cette couche un masque dans lequel ont été ménagées des ouvertures disposées selon des lignes sensiblement équidistantes de pas donné de manière à permettre par décapage à l'aide d'une solution dont la composition en volume est de l'ordre de 96 $H_2SO_4$-2$H_2O_2$ -2$H_2O$, la réalisation d'ouvertures 3. Les parties subsistantes 4 de la couche 2 constituent des régions conductrices disposées selon des lignes.

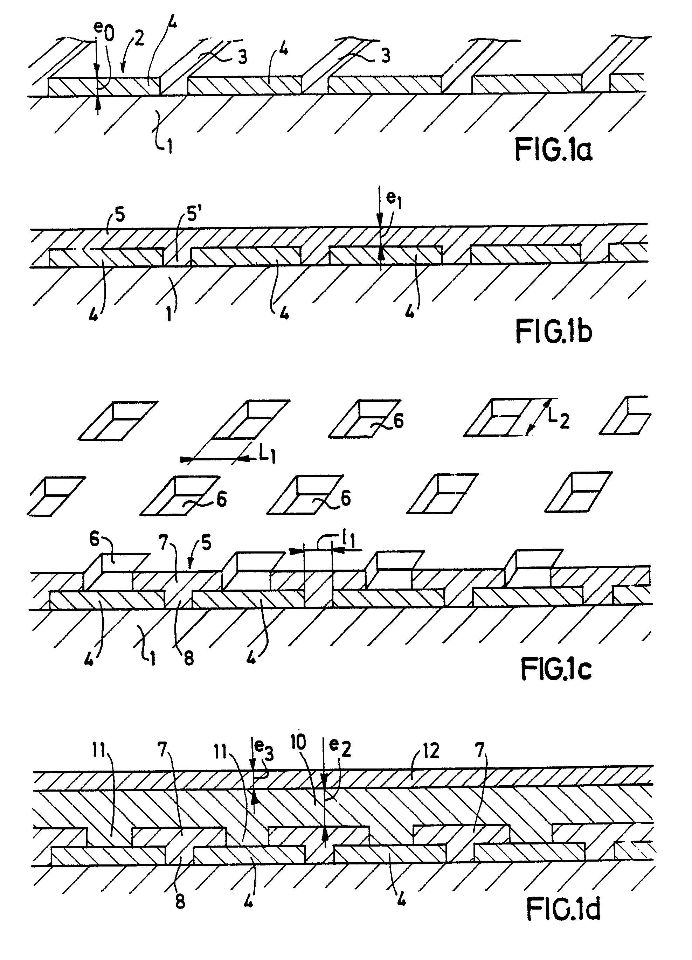

Selon la figure 1b, on réalise ensuite par épitaxie le dépôt d'une couche 5 en GaAs de type n (dopage de l'ordre de 10 cm$^{-3}$), d'une surépaisseur $e_1$ d'environ 2 à 4 microns.

Selon la figure 1c, cette couche 5 est revêtue d'un masque dans lequel ont été ménagées des ouvertures formant un réseau à deux dimensions lequel est, selon les lignes, de même pas que pour la figure 1a, mais décalé latéralement d'un demi-pas. A l'aide d'une solution de $H_2SO_4$-$H_2O_2$ -$H_2O$ telle que mentionnée ci-dessus, on décape des ouvertures 6. Il subsiste alors de la couche 5 un réseau à deux dimensions de zones de localisation espacées les unes des autres et comprenant selon les lignes et les colonnes chacune une partie supérieure 7 et une partie inférieure 8.

Selon la figure 1d, on réalise par épitaxie une couche active 10 en Ga$_{0.65}$Al$_{0.35}$As de type p d'une surépaisseur $e_2$ de 4 à 8 microns environ (dopage de 1 à 4·$10^{18}$cm$^{-3}$) puis une couche d'injection 12 en Ga$_{0.3}$Al$_{0.7}$As de type n d'épaisseur $e_3$ égale à 4 à 5 microns environ, ceci convenant pour une émission dans le rouge (environ 650 nm).

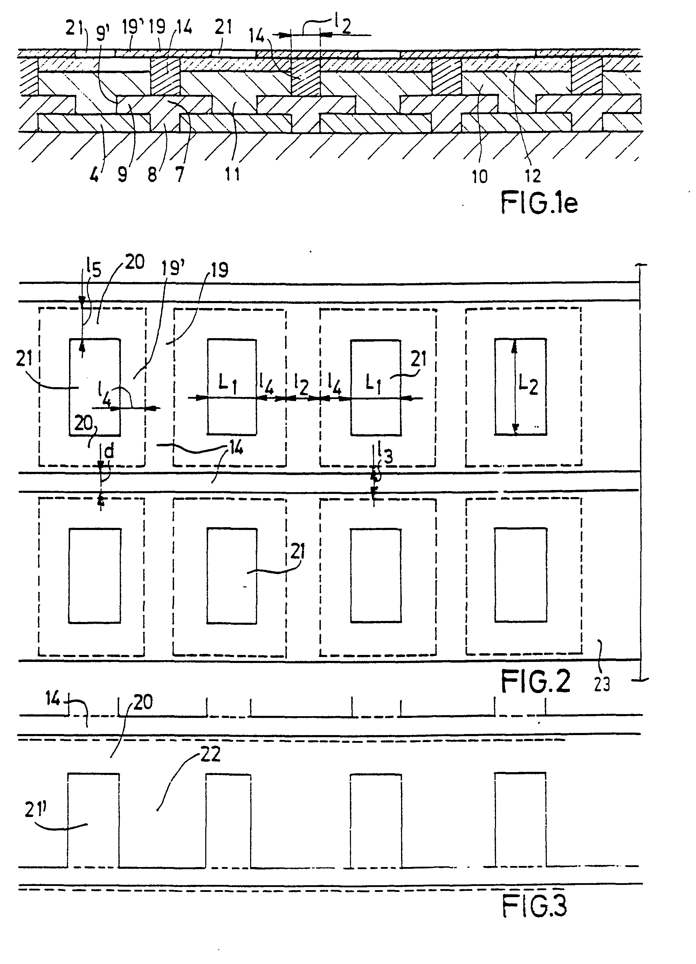

Selon la figure 1e, on réalise un bombardement de protons à travers un masque en polyimide ou bien encore métallique par exemple en or, de manière à rendre semi-isolantes des zones 14 disposées en lignes et en colonnes. Ces zones 14 réalisent la séparation entre les diodes individuelles de la matrice. Elles s'étendent depuis la surface de la couche 12 jusqu'au niveau des parties supérieures 7 des zones de localisation.

La connexion ligne par ligne des diodes étant réalisée par les régions semi-conductrices fortement dopées 4, on réalise des métallisations 19, 20 destinées à connecter les diodes colonne par colonne. La partie active du contact au niveau de chaque diode est constituée latéralement par la région 19' et transversalement par la région 20 (voir fig. 2) ces repères désignant des régions de métallisation en surplomb des zones de localisation 9. Ces régions actives 19' et 20 s'étendent intérieurement parallèlement à la direction des lignes et des colonnes jusqu'à l'aplomb du bord 9' des zones de localisation 9.

A la figure 2 constituant un mode de réalisation préféré on a représenté en pointillé le contour des zones semi-isolantes 14. A chaque pas, les bandes longitudinales présentent des bandes transversales 19 situées sur les zones semi-isolantes 14 disposées selon les lignes et qui se prolongent latéralement de part et d'autre par lesdites régions actives 19', de manière à réaliser ladite connexion des diodes colonne par colonne.

La structure ainsi obtenu se définit alors sur le plan fonctionnel de la manière suivante.

Comme mentionné ci-dessus, les régions semi-conductrices fortement dopées 4 interconnectent les zones actives 10, 11 des diodes ligne par ligne sur la face inférieure de la matrice alors que les métallisations 19, 20 interconnectent les zones d'injection de celles-ci colonne par colonne sur la face supérieure ou face d'émission de la matrice, la prise de contact s'effectuant pour chaque diode dans les régions actives 19' et 20 entourant une ouverture 21 à l'aplomb des ouvertures 6 et de même dimensions (L$_1$ parallèlement aux colonnes et L$_2$ parallèlement aux lignes). Les métallisations 19, 20 sont de ce fait situées en dehors de la zone active d'émission lumineuse de chaque diode, laquelle est délimitée par les zones de localisation 7, 9. Dans la direction des colonnes, les zones semi-isolantes 14 permettent d'isoler électriquement les unes des autres les métallisations reliant les diodes colonne par colonne.

En ce qui concerne les caractéristiques dimensionnelles de la matrice, l'épaisseur $e_0$ de la couche 2 dépend (toutes choses égales par ailleurs) de la résistance série admissible. La largeur l$_1$ des zones 8 est de préférence aussi réduite que possible, d'une part parce qu'elles ne remplissent qu'une fonction d'isolement électrique entre les régions 4 adjacentes (diode en inverse) et d'autre part parce que la couche de localisation 7 n'ayant pas besoin d'avoir une épaisseur supérieure à quelques microns, il ne se produit lors de l'épitaxie qu'une compensation imparfaite du gradin produit par les ouvertures 3, se traduisant par des inégalités de niveau à la surface de la couche 5 qu'il est préférable de ne pas trop accentuer. On notera que ces inégalités de niveau sont sans influence sur le fonctionnement car intervenant à des endroits où les couches ultérieurement déposées sont rendues par la suite semi-isolantes.

La surépaisseur $e_2$ de la couche 10 et l'épaisseur $e_3$ de la couche 12 ainsi que le dopage de celles-ci sont choisis de manière classique. La largeur $l_2$ des zones semi-isolantes 14 situées dans la direction des lignes est choisie de manière à assurer un bon isolement électrique entre les diodes, et leur largeur $l_3$ dans la direction des colonnes pour qu'une isolation satisfaisante entre les métallisations puisse être obtenue. De même la largeur $l_4$ et $l_5$ des régions actives respectivement 19' et 20 des métallisations doit être suffisante pour une bonne prise de contact ; ce critère est aisé à satisfaire sans augmentation notable de l'écart entre les diodes étant donné que le contact a lieu sur tout le pourtour.

En ce qui concerne les prises de contact, celles-ci sont obtenues à la face supérieure sur des plages 23 situées en bout de colonne à l'extrémité des métallisations 19, 20. En ce qui concerne les régions conductrices 4, la prise de contact est avantageusement obtenue à l'extrémité de chaque ligne à travers des ouvertures ménagées de manière connue en soi à partir d'une des faces de la matrice.

A titre d'exemple, et pour un pas du réseau de diodes de 50 X 100 microns au pas de 190 microns parallèlement aux lignes, et de 150 microns selon les colonnes ; avec $L_1 = 50\,\mu$ et $L2 = 100\,\mu$ on pourra prendre $l_1 = 30\,\mu$, $l_2 = l_3 = 30\,\mu$, $l_4 = 35\,\mu$, et $l_5 = 30\,\mu$, la distance d séparant les métallisations des colonnes adjacentes étant alors égale à $l_3$ soit $30\,\mu$.

Selon la variante de la figure 3, chaque métallisation comporte une seule bande longitudinale 20 située sur les zones semi-isolantes 14 disposées selon les colonnes. A chaque pas, la bande 20 est prolongée par une bande transversale 22 de manière à entourer chaque diode individuelle sur trois côtés d'une ouverture 21' située à l'aplomb de l'ouverture 6 correspondante et de même dimensions que celle-ci. On remarquera que dans ce mode de réalisation, on n'a pas représenté de zones semi-isolantes 14 disposées selon les lignes. Une telle suppression pourrait être également effectuée dans le cas des figures précédentes. En effet, la seule fonction des zones semi-isolantes 14 disposées selon les lignes est d'apporter une isolation électrique optimale entre les diodes adjacentes. En fait, cette isolation n'est pas une nécessité absolue, et ce pour deux raisons. D'une part, la couche de localisation 7 d'une diode donnée dirige perpendiculairement au plan du substrat les lignes de courant entre la région 4 formant contact de ligne et la métallisation 19, 20 formant contact de colonne de la diode considérée, et d'autre part le chemin de fuite entre le contact de ligne 4 et une métallisation adjacente est assez long du fait que le pas des diodes de la matrice est beaucoup plus important que la surépaisseur $e_2$ de la couche 10 et l'épaisseur $e_3$ de la couche 12 à travers lesquelles la conduction normale s'effectue. De ce fait, l'émission des zones semi-isolantes 14 disposées selon les lignes ne peut entraîner au pire qu'un faible éclairement parasite de deux diodes adjacentes à une diode normalement éclairée.

L'invention ne se limite pas aux modes de réalisation décrits et représentés. Ainsi, on pourra réaliser des couches actives et/ou des couches d'injection de composition binaire, par exemple en AsGa, ainsi qu'il est d'ailleurs connu.

## Revendications

1. Matrice de diodes électroluminescentes comportant au moins une couche active (10) en matériau III-V d'un premier type de conductivité et une couche superficielle d'injection (12) en matériau III-V du second type de conductivité opposé et des zones semi-isolantes (14) disposées au moins selon des colonnes et s'étendant sur l'épaisseur de la couche d'injection (12) et de la couche active (10) de manière à séparer au moins partiellement dans lesdites couches les diodes individuelles et à recevoir au moins une partie des contacts conducteurs caractérisé en ce que chaque zone semi-isolante (14) s'étend depuis la surface de la couche d'injection (12) jusqu'à une zone de localisation (7, 8) en matériau III-V de composition binaire et du second type de conductivité, les zones de localisation présentant en section transversale chacune une partie supérieure (7) et une partie inférieure (8), les parties supérieures (7) délimitant un réseau à deux dimensions d'alvéoles remplies par des prolongements (11) de la couche active (10), et les parties inférieures (8) étant espacées par des régions semi-conductrices de contact électrique (4) à niveau de dopage élevé du premier type de conductivité, disposées parallèlement aux lignes de manière à interconnecter les diodes ligne par ligne au niveau desdits prolongements (11) et en ce qu'elle comporte, sur la couche d'injection (12) des métallisations de contact électrique (19, 20) comprenant, pour chaque diode, des régions de contact (19) s'étendant intérieurement sensiblement jusqu'à l'aplomb des parties supérieures (7) des zones de localisation et interconnectées colonne par colonne, les colonnes d'interconnexion étant isolées électriquement les unes par rapport aux autres par les zones semi-isolantes (14) disposées selon les colonnes.

2. Matrice selon la revendication 1 caractérisée en ce que la couche active (10) est de composition ternaire.

3. Matrice selon une des revendications 1 ou 2 caractérisée en ce que la couche d'injection (12) est de composition ternaire.

4. Matrice selon une des revendications 1 à 3 caractérisée en ce qu'elle comporte une couche de substrat (1) de composition binaire III-V.

5. Matrice selon une des revendications précédentes caractérisée en ce que la composition binaire est le GaAs et la composition ternaire, le GaAlAs.

6. Matrice selon une des revendications précédentes caractérisée en ce que les zones semi-isolantes (14) s'étendent également selon les lignes de manière à produire une isolation électrique entre les diodes adjacentes.

7. Procédé de fabrication d'une matrice de diodes électroluminescentes selon une des revendications précédentes dans lequel une couche d'injection (12) et d'une couche active (10) du type III-V sont réalisées par hétéro-épitaxie sur un substrat (1) et dans lequel les diodes individuelles sont séparées au moins partiellement en bombardant des régions délimitées pour former au moins des colonnes de zones semi-isolantes sur l'épaisseur de la couche d'injection et de la couche active caractérisé en ce qu'il comporte les étapes suivantes :

-dépôt épitaxique sur ledit substrat d'une première couche III-V (4) de composition binaire fortement dopée d'un premier type de conductivité (p)

-décapage dans ladite première couche III-V d'un premier groupe de lignes d'ouvertures (3) disposées parallèlement aux lignes selon un pas donné, les parties subsistantes de la première couche formant des régions semi-conductrices de contact électrique (4) interconnectant les diodes ligne par ligne.

-dépôt épitaxique d'une deuxième couche III-V (5) de composition binaire du second type de conductivité (n).

-dans le but de former une couche de localisation, décapage dans ladite deuxième couche III-V d'un second groupe d'ouvertures (6) formant un réseau à deux dimensions décalé selon les lignes d'un demi pas par rapport à celles du premier groupe (3), lesdites ouvertures (6) de la deuxième couche étant ménagées à une partie supérieure (7) de la couche de localisation qui recouvre en partie lesdites régions semi-conductrices de contacts électriques

-dépôt épitaxique successivement de ladite couche active (10) d'un premier type de conductivité et de ladite couche d'injection (12) d'un second type de conductivité.

-réalisation dudit bombardement,

-réalisation de métallisations de contact électrique (19, 20) sur la couche d'injection (12), lesquelles comportent pour chaque diode des régions de contact (19) s'étendant intérieurement parallèlement aux lignes sensiblement jusqu'à l'aplomb des parties supérieures (7) de la couche de localisation et interconnectées colonne par colonne, les colonnes d'interconnexion ainsi constituées étant isolées électriquement les unes par rapport aux autres par les zones semi-isolantes disposées selon les colonnes.

8. Procédé selon la revendication 7 caractérisé en ce que l'étape de bombardement est telle qu'elle forme également des lignes de régions semi-isolantes (14) de manière à produire une isolation électrique optimale entre les diodes adjacentes.

9. Procédé selon une des revendications 7 ou 8 ; caractérisé en ce que le substrat (1) est une couche de composition binaire III-V, intrinsèque ou du second type de conductivité (n).

10. Procédé selon une des revendications 7 à 9, caractérisé en ce que la couche active (10) et la couche d'injection (12) ont leur composition choisie parmi le Ga-As et le GaAlAs·en GaAlAs.

## Claims

1. A matrix of light-emitting diodes comprising at least one active layer (10) of a III-V material of a first conductivity type and a superficial injection layer (12) of a III-V material of the second opposite conductivity type and semi-insulating zones (14) arranged at least in columns and extending over the thickness of the injection layer (12) and of the active layer (10) so that they separate at least in part in the said layers the individual diodes from each other and comprise at least a part of the conducting contacts, characterized in that each semiinsulating zone (14) extends from the surface of the injection layer (12) to a localization zone (7, 8) of III-V material of a binary composition and of the second conductivity type, the localization zones each having in crosssection an upper part (7) and a lower part (8), the said upper parts (7) defining a bidimensional lattice of cells filled by prolonged parts (11) of the active layer (10), and said lower parts (8) being spaced apart by semiconducting electrical contact regions (4) at a high doping level of the first conductivity type arranged parallel to lines so that they interconnect the diodes linewise at the level of said prolonged parts (11) and in that it comprises on the injection layer (12) electrical contact metallizations (19, 20) having for each diode contact regions (19) extending internally substantially above the upper parts (7) of the localization zones and interconnected columnwise, the interconnection columns being electrically insulated from each other by the said semi-insulating zones (16) arranged in columns.

2. A matrix as claimed in Claim 1, characterized in that the active layer (10) is of a ternary composition.

3. A matrix as claimed in any one of Claims 1 or 2, characterized in that the injection layer (12) is of a ternary composition.

4. A matrix as claimed in any one of Claims 1 to 3, characterized in that it comprises a substrate layer (1) of a binary III-V composition.

5. A matrix as claimed in any one of the preceding Claims, characterized in that the binary composition is GaAs and the ternary composition is GaAlAs.

6. A matrix as claimed in any one of the preceding Claims, characterized in that the semi-insulating zones (14) also extend in lines so that they provide an electrical insulation between the adjacent diodes.

7. A method of manufacturing a matrix of lightemitting diodes as claimed in any one of the preceding Claims, in which an injection layer (12) and an active layer (10) of the III-V type are formed by hetero-epitaxy on a substrate (1) and in which the individual diodes are separated at least in part by bombarding regions defined so that at least columns of semi-insulating zones are formed over the thickness of the injection layer and of the active layer, characterized in that it comprises the following steps :

-epitaxially depositing on said substrate a first III-V semiconductor layer (4) of a highly doped binary composition of a first conductivity type (p) ;

-etching in said first III-V layer a first group of lines of openings (3) arranged parallel to the lines according to a given pitch, the subsisting parts of the first layer forming semiconducting electrical contact regions (4) interconnecting the diodes linewise ;

-epitaxially depositing a second III-V layer (5) of a binary composition of the second conductivity type (n) ;

-in order to obtain a localization layer, etching in said second III-V layer a second group of openings (6) forming a bidimensional lattice offset along the lines by half a pitch with respect to those of the first group (3), the said openings (6) of the second layer being formed in an upper part (7) of the localization layer which covers in part the said semiconducting electrical contact regions ;

-epitaxially depositing successively said active layer (10) of a first conductivity type and said injection layer (12) of a second conductivity type ;

-carrying out the said bombardment ;

-forming electrical contact metallizations (19, 20) on the injection layer (12), which comprise for each diode contact regions (19) extending internally parallel to the lines substantially above the upper parts (7) of the localization layer and interconnected columnwise, the interconnection columns thus constituted being electrically insulated from each other by the semi-insulating zones arranged in columns.

8. A method as claimed in Claim 7, characterized in that the bombardment step is such that also lines of semi-insulating regions (14) are formed so that an optimum electrical insulation is obtained between the adjacent diodes.

9. A method as claimed in any one of Claims 7 or 8, characterized in that the substrate (1) is a layer of a binary III-V composition which is intrinsic or of the second conductivity type (n).

10. A method as claimed in any one of Claims 7 to 9, characterized in that the active layer (10) and the injection layer (12) have compositions chosen from GaAs and GaAlAs.

**Patentansprüche**

1. Leuchtdiodenanordnung mit mindestens einer aktiven Schicht (10) aus III-V-Material eines ersten Leitungstyps und einer Oberflächeninjektionsschicht (12) aus III-V-Material des zweiten entgegengesetzten Leitungstyps sowie mit halbisolierenden Zonen (14), die wenigstens in Spalten angeordnet sind und sich derart über die Dicke der Injektionsschicht (12) und der aktiven Schicht (10) erstrecken, dass sie wenigstens teilweise in den Schichten die einzelnen Dioden voneinander trennen und wenigstens einen Teil der leitenden Kontakte aufweisen, dadurch gekennzeichnet, dass jede halbisolierende Zone (14) sich von der Oberfläche der Injektionsschicht (12) bis an eine Begrenzungszone (7, 8) aus III-V-Material einer binären Zusammensetzung und vom zweiten Leitungstyp erstreckt, wobei die Begrenzungszonen im Schnitt je einen oberen Teil (7) und einen unteren Teil (8) aufweisen, wobei die oberen Teile (7) ein zweidimensionales Zellengitter definieren, wobei die Zellen durch verlängerte Teile (11) der aktiven Schicht (10) gefüllt sind und wobei die unteren Teile (8) durch halbleitende elektrische Kontaktgebiete (4) mit einem hohen Dotierungspegel vom ersten Leitungstyp getrennt sind, wobei diese Kontaktgebiete derart parallel zeilenweise vorgesehen sind, dass sie die Dioden auf dem Pegel der verlängerten Teile (11) zeilenweise miteinander verbinden und dass die Anordnung auf der Injektionsschicht (12) elektrische Kontaktmetallisierungen (19, 20) aufweist, wobei sich für jede Diode Kontaktgebiete (19) innerhalb im wesentlichen bis an die oberen Teile (7) der Begrenzungszonen erstrecken und spaltenweise miteinander verbunden sind, wobei die Verbindungsspalten durch die spaltenweise vorgesehenen halbisolierenden Zonen (14) voneinander getrennt sind.

2. Anordnung nach Anspruch 1, dadurch gekennzeichnet, dass die aktive Schicht (10) ternärer Zusammensetzung ist.

3. Anordnung nach einem der Ansprüche 1 oder 2, dadurch gekennzeichnet, dass die Injektionsschicht (12) ternärer Zusammensetzung ist.

4. Anordnung nach einem der Ansprüche 1 bis 3, dadurch gekennzeichnet, dass sie eine Substratschicht (1) binärer Zusammensetzung III-V aufweist.

5. Anordnung nach einem der vorstehenden Ansprüche, dadurch gekennzeichnet, dass die binäre Zusammensetzung GaAs und die ternäre Zusammensetzung GaAlAs ist.

6. Anordnung nach einem der vorstehenden Ansprüche, dadurch gekennzeichnet, dass die halbisolierenden Zonen (14) sich ebenfalls derart zeilenweise erstrecken, dass sie zwischen den benachbarten Dioden eine elektrische Isolierung bilden.

7. Verfahren zum Herstellen einer Leuchtdiodenanordnung nach einem der vorstehenden Ansprüche, wobei eine Injektionsschicht (12) und eine aktive Schicht (10) vom Typ III-V durch Hetero-Epitaxie auf einem Substrat (1) gebildet werden und wobei die einzelnen Dioden wenigstens teilweise durch Bombardierung von Gebieten voneinander getrennt sind, wobei diese Gebiete derart definiert sind, dass über die Dicke der Injektionsschicht und der aktiven Schicht wenigstens Spalten halbisolierender Zonen gebildet werden, dadurch gekennzeichnet, dass dieses Verfahren die folgenden Verfahrensschritte aufweist :

-epitaxiale Auftragung einer ersten, hochdotierten Schicht III-V (4) binärer Zusammensetzung vom ersten Leitungstyp (p) auf dem Substrat,

-das Ätzen einer ersten Gruppe von Zeilen von Öffnungen (3) parallel zu den Zeilen entsprechend einer bestimmten Steigung in der ersten Schicht III-V, wobei die Substitutionsteile der ersten Schicht die Dioden zeilenweise miteinander verbindende halbleitende elektrische Kontaktgebiete (4) bilden,

-epitaxiale Auftragung einer zweiten Schicht III-V (5) binärer Zusammensetzung vom zweiten zweiten Leitungstyp (n),

-zum Bilden einer Begrenzungsschicht, das Ätzen einer zweiten Gruppe von Öffnungen (6) in der zweiten Schicht III-V, die ein zweidimensionales Gitter bilden, das gegenüber dem der ersten Gruppe (3) um einen halben Steigungsschritt entsprechend den Zeilen verschoben ist, wobei diese Öffnungen (6) der zweiten Schicht in einem oberen Teil (7) der Begrenzungsschicht vorgesehen sind, der die halbleitenden elektrischen Kontaktgebiete teilweise bedeckt,

-aufeinanderfolgende epitaxiale Auftragung der aktiven Schicht (10) eines ersten Leitungstyps und der Injektionsschicht (12) eines zweiten Leitungstyps,

- das Durchführen der Bombardierung,

-das Herstellen elektrischer Kontaktmetallisierungen (19, 20) auf der Injektionsschicht (12), die für jede Diode Kontaktgebiete (19) aufweisen, die sich innerhalb parallel zu den Zeilen im wesentlichen bis über die oberen Teile (7) der Begrenzungsschicht erstrecken und spaltenweise miteinander verbunden sind, wobei die auf diese Weise gebildeten Verbindungsspalten durch die halbisolierenden spaltenweise vorgesehenen Zonen gegen einander elektrisch isoliert sind.

8. Verfahren nach Anspruch 7, dadurch gekennzeichnet, dass der Bombardierungsschritt derart ist, dass dabei ebenfalls Zeilen halbisolierender Gebiete (14) auf eine solche Weise gebildet werden, dass eine optimale elektrische Isolierung zwischen den benachbarten Dioden erhalten wird.

9. Verfahren nach einem der Ansprüche 7 oder 8, dadurch gekennzeichnet, dass das Substrat (1) eine Schicht intrinsiker, binärer Zusammensetzung III-V oder vom zweiten Leitungstyp (n) ist.

10. Verfahren nach einem der Ansprüche 7 bis 9, dadurch gekennzeichnet, dass die aktive Schicht (10) und die Injektionsschicht (12) eine Zusammensetzung aus Ga-As oder GaAlAs aufweisen.

FIG.1a

FIG.1b

FIG.1c

FIG.1d

FIG.1e

FIG.2

FIG.3